# DEMANDE DE BREVET EUROPEEN

(11) **EP 4 658 034 A1**
(43) Date de publication de la demande: **03.12.2025**
(21) Numéro de dépôt: 25178601.8
(22) Date de dépôt: 23.05.2025
(51) Int. Cl.: H10H 20/816, H10H 20/818, H10H 20/819, H10H 20/821, H10H 20/81, H10H 20/01, H10H 29/01, H10H 29/14, H10H 20/813, H10H 20/822, H10H 20/825, H10H 20/831, H10H 20/832, H10H 20/833, H10H 20/84

(54) **DIODE ÉLECTROLUMINESCENTE ET SON PROCÉDÉ DE FABRICATION**

(30) Priorité: 30.05.2024 FR 2405604
(71) Demandeur: Aledia, 38800 Champagnier (FR)
(72) Inventeur: Pourquier, Eric, 34430 Saint Jean de Vedas (FR)
(74) Mandataire: Hautier IP

(57) **Abrégé**

L'invention a pour objet une diode électroluminescente dotée d'au moins une structure tridimensionnelle (20) comprenant :
- une première partie (21) présentant une première conductivité,
- une deuxième partie (23) présentant une deuxième conductivité,
- une région active (22) configurée pour émettre un rayonnement lumineux, intercalée entre la première partie (21) et la deuxième partie (23),
la diode comprenant également :
- un premier contact électrique (31) configuré pour injecter des porteurs dans la première partie (21),
- un deuxième contact électrique (32) configuré pour injecter des porteurs dans la deuxième partie (23).

La diode comprend en outre une couche de ralentissement (33) intercalée entre le premier contact (31) et la première partie (21), configurée pour ralentir les porteurs issus du premier contact (31) avant d'être injectés dans la première partie (21).

L'invention a également pour objet un procédé de fabrication d'une telle diode électroluminescente.

## Description

### DOMAINE TECHNIQUE

La présente invention concerne le domaine de l'optoélectronique. Elle trouve pour application particulièrement avantageuse la fabrication de dispositifs optoélectroniques présentant une structure tridimensionnelle (3D), par exemple des diodes électroluminescentes à base de nanofils.

### ETAT DE LA TECHNIQUE

Une diode électroluminescente (LED) comprend typiquement des régions d'injection de porteurs (électrons et trous) entre lesquelles est intercalée une région active. La région active est le lieu où se produisent des recombinaisons radiatives de paires électron-trou, qui permettent d'obtenir une émission de lumière. Cette région active peut notamment comprendre des puits quantiques, par exemple à base d'InGaN.

Les LED présentant une structure tridimensionnelle (LED 3D), typiquement sous forme de nanofils ou de nanopyramides, peuvent présenter différentes architectures, notamment au niveau de l'agencement des différentes régions constitutives de la LED.

Ces différentes régions peuvent être disposées en empilement selon une direction longitudinale z. Une telle architecture de LED est dite axiale. Une LED 3D axiale présente typiquement, en empilement selon z, une partie inférieure prenant appui sur un substrat, une région active prenant appui sur la partie inférieure, et une partie supérieure prenant appui sur la région active. La partie inférieure est généralement destinée à l'injection d'électrons et la partie supérieure à l'injection de trous. La région active présente typiquement des puits quantiques s'étendant de façon transverse à la direction longitudinale z.

Alternativement, les différentes régions de la LED peuvent être disposées radialement autour de la direction longitudinale z. Une telle architecture de LED est dite radiale ou cœur-coquille. Une LED 3D radiale présente typiquement une partie interne (le cœur) allongée selon z et prenant appui sur un substrat, une région active entourant la partie interne, et une partie externe (la coquille) entourant la région active. La partie interne est généralement destinée à l'injection d'électrons et la partie externe à l'injection de trous. La région active présente typiquement des puits quantiques s'étendant de façon parallèle à la direction longitudinale z.

Pour améliorer le taux de recombinaisons radiatives, c'est-à-dire l'efficacité quantique externe (EQE) des LED, une solution consiste à confiner les porteurs au sein de la région active en ajoutant une ou plusieurs couches de blocage de porteurs autour de la région active.

En particulier, une couche de blocage d'électrons (EBL) peut être ajoutée entre la région d'injection de trous et la région active. Cette couche EBL évite que les électrons issus de la région d'injection d'électrons traversent la région active sans se recombiner. La couche EBL est configurée pour bloquer les électrons et laisser passer les trous.

De façon corollaire, une couche de blocage de trous (HBL) peut être ajoutée entre la région d'injection d'électrons et la région active. Cette couche HBL évite que les trous issus de la région d'injection de trous traversent la région active sans se recombiner. La couche HBL est configurée pour bloquer les trous et laisser passer les électrons.

En pratique, l'introduction de ces couches EBL et/ou HBL engendre d'autres problèmes, notamment l'apparition de défauts structuraux, l'apparition de résistances électriques en série et/ou un ralentissement indésirable des porteurs qui doivent passer au travers de ces couches. D'un point de vue technologique, la formation des couches EBL et/ou HBL dans des architectures de LED 3D n'est pas suffisamment maîtrisée.

Il existe donc un besoin consistant à concevoir une architecture de LED 3D présentant une EQE améliorée. La présente invention vise à répondre à ce besoin et/ou à pallier au moins partiellement les inconvénients mentionnés ci-dessus.

En particulier, un objet de la présente invention est de proposer une diode électroluminescente à structure 3D, radiale ou axiale, présentant une EQE optimisée. Un autre objet de la présente invention est de proposer un procédé de fabrication d'une telle diode électroluminescente.

Les autres objets, caractéristiques et avantages de la présente invention apparaîtront à l'examen de la description suivante et des dessins d'accompagnement. Il est entendu que d'autres avantages peuvent être incorporés. En particulier, certaines caractéristiques et certains avantages du dispositif peuvent s'appliquer mutatis mutandis au procédé, et réciproquement.

### RESUME

Pour atteindre les objectifs mentionnés ci-dessus, un premier aspect de l'invention concerne une diode électroluminescente comprenant au moins une structure tridimensionnelle (3D) comprenant :
- une première partie présentant une première conductivité d'un premier type de porteurs,
- une deuxième partie présentant une deuxième conductivité d'un deuxième type de porteurs,
- une région active configurée pour émettre ou recevoir un rayonnement lumineux de longueur d'onde λ, ladite région active étant intercalée entre la première partie et la deuxième partie.

La diode comprend en outre :
- un premier contact électriquement conducteur configuré pour injecter des porteurs du premier type dans la première partie,
- un deuxième contact électriquement conducteur configuré pour injecter des porteurs du deuxième type dans la deuxième partie.

Avantageusement, la diode électroluminescente comprend une couche de ralentissement de porteurs intercalée entre le premier contact et la première partie de la structure 3D. Cette couche de ralentissement est configurée pour ralentir les porteurs du premier type issus du premier contact avant d'être injectés dans la première partie.

Dans le cadre du développement de la présente invention, il a été observé que l'efficacité des LEDs est diminuée par la très grande différence de vitesses entre les électrons et les trous. Cette différence limite les possibilités de recombinaisons. Les électrons peuvent traverser la région active rapidement sans rencontrer des trous. Un moyen de ralentir les électrons a donc été développé.

Ainsi, la première partie et le premier contact ne sont pas directement au contact l'un de l'autre. La couche de ralentissement est une couche intermédiaire assurant un contact ohmique entre le premier contact et la première partie de la structure 3D. Les porteurs du premier type sont typiquement des électrons. La première partie de la structure 3D est typiquement à base de GaN-n. La couche de ralentissement peut être à base d'un matériau semiconducteur magnétique dilué (DMS), par exemple à base de ZnO dopé cobalt.

Le matériau DMS provoque typiquement une modification de la trajectoire des électrons transportés vers la première partie en GaN-n. Cette altération de la trajectoire des électrons peut résulter d'une interaction entre les spins des électrons et les spin-orbits des atomes ferromagnétiques du matériau DMS.

Le matériau DMS permet avantageusement d'injecter les électrons dans la première partie en GaN-n, selon des trajectoires aléatoires ou désordonnées. En particulier les trajectoires des électrons présentent une composante perpendiculaire au champ électrique. La mobilité apparente des électrons est donc diminuée.

Cette mobilité plus faible des électrons est maintenue dans la première partie de la structure 3D jusqu'aux zones de recombinaison électrons/trous, dans la région active. Cela favorise les recombinaisons radiatives entre électrons et trous. L'efficacité EQE de la LED est améliorée. Cet effet de ralentissement des électrons est d'autant plus prononcé et persistant que la couche de ralentissement est disposée à proximité de la région active, dans la structure 3D selon la présente invention. Le bénéfice du ralentissement est ainsi maximisé. Cela est particulièrement avantageux pour augmenter le taux de recombinaisons radiatives entre électrons et trous dans la région active d'une LED à structure 3D selon la présente invention.

Un deuxième aspect de l'invention concerne un procédé de fabrication d'une diode électroluminescente selon le premier aspect. Ce procédé comprend notamment les étapes suivantes :
- former la première partie par épitaxie sur un substrat de croissance, par croissance localisée au travers d'une ouverture d'une couche de masquage disposée sur ledit substrat de croissance,
- former par épitaxie la région active sur la première partie,
- former par épitaxie la deuxième partie sur la région active, puis
- former le deuxième contact sur la deuxième partie, par dépôt d'une couche d'oxyde conducteurr transparent,
- déposer une couche de planarisation sur le substrat de croissance, sur et autour de l'au moins une structure 3D en saillie du substrat de croissance, de façon à obtenir une surface plane au-dessus de l'au moins une structure 3D,
- coller un substrat de manipulation sur ladite surface plane,
- retirer le substrat de croissance de façon à exposer une portion de la première partie au travers de la couche de masquage,
- former la couche de ralentissement au contact de la portion exposée de la première partie,
- former le premier contact sur la couche de ralentissement.

### BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
La FIGURE 1 illustre une LED 3D radiale comprenant une couche de ralentissement d'électrons, selon un mode de réalisation de la présente invention.
Les FIGURES 2 à 13 illustrent schématiquement différentes étapes d'un procédé de réalisation d'une LED 3D à couche de ralentissement d'électrons, selon un mode de réalisation de la présente invention.
La FIGURE 14 illustre schématiquement une variante de réalisation du premier contact de la LED 3D, selon un mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les dimensions des différentes couches et des différentes parties de la LED 3D ne sont pas forcément représentatives de la réalité.

### DESCRIPTION DÉTAILLÉE

Avant d'entamer une revue détaillée de modes de réalisation de l'invention, il est rappelé que l'invention selon son premier aspect comprend notamment les caractéristiques optionnelles ci-après pouvant être utilisées en association ou alternativement :
Selon un exemple, les porteurs du premier type sont des électrons et la première conductivité est de type N, les porteurs du deuxième type sont des trous et la deuxième conductivité est de type P, et la couche de ralentissement est une couche de ralentissement d'électrons à base d'un matériau semiconducteur magnétique dilué.

Selon un exemple, le matériau semiconducteur magnétique dilué est à base de ZnO dopé par au moins un élément pris parmi le cobalt (Co), le manganèse (Mn), le niobium (Nb), le chrome (Cr), le fer (Fe), le nickel (Ni), le néodyme (Nd).

Selon un exemple, la LED 3D comprend en outre une couche de masquage présentant une face dite inférieure, une face dite supérieure, et des ouvertures. Selon un exemple, la première partie traverse la couche de masquage au niveau desdites ouvertures, jusqu'à la couche de ralentissement, la couche de ralentissement étant au contact de la face inférieure de la couche de masquage. Cette caractéristique structurelle de la LED 3D est typiquement liée à un procédé de croissance localisée SAG (acronyme de « Selective Area Growth ») des structures 3D. La présence de la couche de masquage est généralement un élément résiduel de la mise en œuvre d'une croissance localisée SAG. Une telle couche de masquage n'est pas présente dans des LED 2D dites planaires. Des LED structurées en mésa par gravure de couches planaires, selon une approche technologique désignée par les termes « top-down », ne présentent pas de couche de masquage. La couche de masquage est généralement spécifique à la mise en œuvre d'un procédé SAG pour la formation de structures 3D, selon une approche technologique désignée par les termes « bottom-up ». La présence de la couche de masquage est un moyen de différenciation entre des LED 3D « bottom-up » et des LED « top-down » issues de technologies planaires. Selon une possibilité, la première partie prend appui sur la face supérieure de la couche de masquage.

Selon un exemple, la structure tridimensionnelle est obtenue par croissance localisée au travers des ouvertures de la couche de masquage. Les ouvertures de la couche de masquage peuvent être régulièrement distribuées sous forme d'un réseau. Une portion à la base de la première partie de la structure 3D est typiquement enserrée par la couche de masquage. La première partie peut en outre s'élargir au-dessus de la portion enserrée, et prendre appui sur la couche de masquage.

Selon un exemple, la structure 3D présente une architecture dite radiale telle que :
- la première partie s'étend principalement selon une direction z, et présente des flancs sensiblement parallèles à la direction z et un sommet sensiblement perpendiculaire à la direction z,
- la région active comprend une partie dite radiale couvrant les flancs de la première partie, et une partie dite sommitale couvrant le sommet de la première partie,
- la deuxième partie couvre la partie radiale et la partie sommitale de la région active.

Selon un exemple, la partie radiale forme au moins 80% de la région active.

Selon un exemple, la couche de ralentissement s'étend de façon transverse à ladite partie radiale.

Selon un exemple, la première partie et la couche de ralentissement présentent une interface commune. Cette interface s'étend dans un plan xy perpendiculaire à la direction z, sur les figures.

Selon un exemple alternatif, la structure 3D présente une architecture dite axiale formant un empilement selon une direction z tel que :
- la première partie présente des flancs sensiblement parallèles à la direction z et un sommet sensiblement perpendiculaire à la direction z,
- la région active couvre uniquement le sommet de la première partie, et présente des flancs sensiblement parallèles à la direction z à l'aplomb des flancs de la première partie, et un sommet sensiblement perpendiculaire à la direction z,
- la deuxième partie couvre uniquement le sommet de la région active, et présente des flancs sensiblement parallèles à la direction z à l'aplomb des flancs de la région active.

Selon un exemple, les flancs de la première partie, les flancs de la région active et les flancs de la deuxième partie s'étendent sensiblement à l'aplomb les uns des autres. Selon un exemple, ces flancs sont orientés selon des plans cristallographiques m {10-10}.

Selon un exemple, la LED 3D comprend en outre une couche de blocage du premier type de porteurs intercalée entre la deuxième partie et la région active. Un effet synergique entre le ralentissement des porteurs dû à la couche de ralentissement d'une part, et le blocage des porteurs dû à la couche de blocage d'autre part, peut ainsi être obtenu.

Selon un exemple, les première et deuxième parties sont à base de GaN, et la région active comprend des puits quantiques à base d'InGaN.

Selon un exemple, la couche de ralentissement présente, dans un plan xy perpendiculaire à la direction z, au moins une dimension supérieure aux dimensions de la première partie de la structure 3D, prises dans un plan parallèle au plan xy. La couche de ralentissement peut également présenter, dans le plan xy, au moins une dimension supérieure aux dimensions de la région active de la structure 3D, prises dans un plan parallèle au plan xy. La couche de ralentissement peut également présenter, dans le plan xy, au moins une dimension supérieure aux dimensions de la deuxième partie de la structure 3D, prises dans un plan parallèle au plan xy.

Selon un exemple, la couche de ralentissement présente, dans un plan xy perpendiculaire à la direction z, des dimensions inférieures à au moins une dimension du premier contact électriquement conducteur, prise dans un plan parallèle au plan xy.

Selon un exemple, la couche de ralentissement et la structure 3D présentent ensemble une forme de clou (avec ou sans pointe), la couche de ralentissement correspondant à la tête du clou et la structure 3D correspondant au corps ou à la tige du clou.

Selon un exemple, la couche de ralentissement est formée ultérieurement à la formation de la structure 3D, et rapportée à la base de la première partie de la structure 3D. L'interface entre la couche de ralentissement et la première partie de la structure 3D ne montre pas de relation d'épitaxie entre la couche de ralentissement et la première partie de la structure 3D. Ainsi, la structure 3D peut être formée par épitaxie selon une méthode de type « bottom-up », tandis que la couche de ralentissement n'est pas formée selon cette méthode.

Selon un exemple, le substrat de manipulation est à base d'un matériau transparent à la longueur d'onde λ. Le substrat de manipulation peut ainsi être conservé à l'issue du procédé. Alternativement, le substrat de manipulation peut être retiré à l'issue du procédé, typiquement lorsque le substrat de manipulation est à base d'un matériau opaque tel que le silicium.

Selon un exemple, la couche de ralentissement est structurée sous forme de plot, et le premier contact est formé sur et autour dudit plot, en prenant appui sur une face inférieure de la couche de masquage. En particulier, lorsque la LED comprend une pluralité de structures 3D, chaque structure 3D peut être contactée individuellement par l'intermédiaire des plots.

Selon un exemple, le procédé comprend en outre, après formation de la couche de ralentissement, un dépôt d'une couche diélectrique sur la couche de ralentissement, puis une gravure d'un via au travers de la couche diélectrique débouchant sur une face de la couche de ralentissement, et la formation du premier contact au travers dudit via.

Selon un exemple, les formations des première et deuxième parties, et la formation de la région active, sont effectuées par épitaxie en phase vapeur à précurseurs organométalliques MOVPE (acronyme de « Metal Organic Vapour Phase Epitaxy »). Selon un exemple, la première partie, la région active, et la deuxième partie sont en relation d'épitaxie les unes les autres.

Selon un exemple, l'au moins une diode électroluminescente comprend une pluralité de diodes électroluminescentes, et la formation des premières parties est telle que deux premières parties adjacentes sont séparées entre elles par une distance de séparation inférieure à 180 nm, de préférence inférieure ou égale à 100 nm. Les premières parties des diodes sont ainsi réparties sur le substrat avec une densité surfacique élevée. Cela favorise une croissance axiale des parties surmontant chaque première partie, notamment des régions actives.

Sauf incompatibilité, des caractéristiques techniques décrites en détail pour un mode de réalisation donné peuvent être combinées aux caractéristiques techniques décrites dans le contexte d'autres modes de réalisation décrits à titre exemplaire et non limitatif, de manière à former un autre mode de réalisation qui n'est pas nécessairement illustré ou décrit. Un tel mode de réalisation n'est évidemment pas exclu de l'invention.

Dans la présente invention, le dispositif et le procédé se rapportent en particulier à une architecture et à la fabrication de diodes électroluminescentes (LED) à structure 3D. L'invention peut être mise en œuvre plus largement pour différents dispositifs optoélectroniques à structure 3D. L'invention peut donc être également mise en œuvre dans le cadre de dispositifs laser ou photovoltaïque. Dans la présente demande de brevet, les termes « diode électroluminescente », « LED » ou simplement « diode » sont employés en synonymes. Une « LED » peut également s'entendre d'une « micro-LED ».

Dans la présente invention, la couche de ralentissement est de préférence à base d'un matériau semiconducteur magnétique dilué. Un tel matériau est typiquement obtenu en introduisant des impuretés magnétiques dans un semiconducteur. Les propriétés électroniques et magnétiques de ce matériau sont alors fortement couplées.

Parmi les exemples de matériau semiconducteur magnétique dilué, on peut citer les semiconducteurs II-VI, par exemple le ZnO, comprenant une impureté magnétique, par exemple le manganèse ou le cobalt ou le nickel - en substitution du zinc.

Sauf mention explicite, il est précisé que, dans le cadre de la présente invention, la disposition relative d'une troisième couche intercalée entre une première couche et une deuxième couche, ne signifie pas obligatoirement que les couches sont directement au contact les unes des autres, mais signifie que la troisième couche est soit directement au contact des première et deuxième couches, soit séparée de celles-ci par au moins une autre couche ou au moins un autre élément. Ainsi, les termes et locutions « prendre appui » et « couvrir » ou « recouvrir » ne signifient pas nécessairement « au contact de ». Typiquement, la deuxième partie prend appui sur la région active soit directement, soit indirectement, par exemple par l'intermédiaire d'une couche de blocage d'électrons intercalée. La région active peut prendre appui sur la première partie soit directement, soit indirectement, par exemple par l'intermédiaire d'une barrière quantique intercalée.

Les LED selon la présente invention sont de préférence à base de matériaux III-V, notamment à base de GaN. Les différentes parties et régions de la LED présentent typiquement une structure cristallographique hexagonale. On notera, selon le système de Miller-Bravais, (hkil) un plan de la structure hexagonale, {hkil} une famille de plans de la structure hexagonale, [hkil] une direction ou un vecteur de la structure hexagonale.

L'efficacité quantique externe EQE peut être décomposée en trois composantes :
- L'efficacité d'injection (IE) des porteurs dans la région active,
- L'efficacité quantique interne (IQE) qui est le ratio entre le nombre de recombinaisons radiatives et le nombre de recombinaisons total,
- L'efficacité d'extraction lumineuse (LEE) qui correspond à la proportion de photons sortant de la LED par rapport au nombre de photons générés.

Le terme « structure 3D » s'entend par opposition aux structures dites planaires ou 2D, qui présentent deux dimensions dans un plan très supérieures à la troisième dimension normale au plan. Ainsi, les structures 3D usuelles visées dans le domaine des LED 3D peuvent se présenter sous forme de fil, de nanofil ou de microfil. Une telle structure 3D présente une forme allongée selon la direction longitudinale. La dimension longitudinale du fil, selon z sur les figures, est supérieure, et de préférence très supérieure, aux dimensions transverses du fil, dans le plan xy sur les figures. La dimension longitudinale est par exemple au moins deux fois, et de préférence au moins dix fois, supérieure aux dimensions transverses, de préférence comprise entre trois fois et cinq fois les dimensions transverses. Dans l'exemple de pyramides, les rapports dimensions longitudinale sur dimensions transverses peuvent être fixes Cela dépend typiquement des géométries des cristaux de GaN. Par exemple, pour une pyramide, le rapport de la dimension longitudinale sur une dimension transverse est sensiblement inférieur ou égal à 0,9. Les structures 3D peuvent également se présenter sous forme de murs. Dans ce cas, seule une dimension transverse du mur est très inférieure aux autres dimensions, par exemple de trois fois à cinq fois inférieure aux autres dimensions. Les structures 3D de la présente demande présentent de préférence des parois ou des flancs sensiblement verticaux. Les parois verticales s'étendent typiquement selon des plans cristallographiques de type m {10-10}. Elles peuvent être impliquées dans un mécanisme de croissance dite radiale. Les structures 3D de la présente demande présentent de préférence des bases et des sommets comprenant des surfaces sensiblement horizontales. Ces surfaces horizontales s'étendent typiquement selon des plans cristallographiques de type c (0001) ou -c (000-1). Elles peuvent être impliquées dans un mécanisme de croissance dite axiale. Selon une possibilité, les structures 3D se présentent sous forme de pyramides ou de nanopyramides. Selon une autre possibilité, les structures 3D se présentent sous forme de pyramides « allongées » ou sous forme de « crayon », typiquement un nanofil surmonté par une pyramide.

On entend par « croissance axiale » une croissance anisotrope se produisant essentiellement voire uniquement selon la direction longitudinale z. On entend par « croissance radiale » une croissance isotrope couvrant notamment les surfaces parallèles à la direction longitudinale z. Les étapes du procédé telles que revendiquées s'entendent au sens large et peuvent éventuellement être réalisées en plusieurs sous-étapes.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants.

Dans la suite, les abréviations suivantes relatives à un matériau M sont éventuellement utilisées :
- a-M réfère au matériau M sous forme amorphe, selon la terminologie habituellement utilisée dans le domaine de la microélectronique pour le préfixe a-.
- p-M réfère au matériau M sous forme polycristalline, selon la terminologie habituellement utilisée dans le domaine de la microélectronique pour le préfixe p-.
- De même, les abréviations suivantes relatives à un matériau M sont éventuellement utilisées :
- M-i réfère au matériau M intrinsèque ou non intentionnellement dopé, selon la terminologie habituellement utilisée dans le domaine de la microélectronique pour le suffixe -i.
- M-n réfère au matériau M dopé N, N+ ou N++, selon la terminologie habituellement utilisée dans le domaine de la microélectronique pour le suffixe -n.
- M-p réfère au matériau M dopé P, P+ ou P++, selon la terminologie habituellement utilisée dans le domaine de la microélectronique pour le suffixe -p.

Un repère, de préférence orthonormé, comprenant les axes x, y, z est représenté sur certaines figures annexées. Ce repère peut s'appliquer par extension aux autres figures annexées. L'axe z est ici parallèle à l'axe c, c'est-à-dire à la direction cristallographique [0001].

Dans la présente demande de brevet, on parlera préférentiellement d'épaisseur pour une couche et de hauteur pour une structure ou un dispositif. L'épaisseur est prise selon une direction normale au plan d'extension principal de la couche, et la hauteur est prise perpendiculairement au plan basal xy du substrat. Ainsi, une couche présente typiquement une épaisseur selon z, lorsqu'elle s'étend principalement le long d'un plan xy, et une LED présente une hauteur selon z. Les termes relatifs « sur », « sous », « sous-jacent » se réfèrent à des positions prises selon la direction z. Les valeurs dimensionnelles s'entendent aux tolérances de fabrication et de mesure près. Les termes « sensiblement », « environ », « de l'ordre de » signifient, lorsqu'ils se rapportent à une valeur, « à 10% près » de cette valeur ou, lorsqu'ils se rapportent à une orientation angulaire, « à 10° près » de cette orientation. Ainsi, une direction sensiblement normale à un plan signifie une direction présentant un angle de 90±10° par rapport au plan.

Une région, une partie ou une couche formée par croissance axiale présente typiquement sensiblement le même diamètre, pris dans un plan xy, que la région, la couche ou la partie sur laquelle elle s'appuie.

Lorsque la LED se présente sous forme d'un nanofil ou d'un microfil, l'homme du métier sait parfaitement différencier une architecture axiale et une architecture radiale.

Pour déterminer la géométrie des structures 3D et les compositions des différents éléments (fil, région active, couche de ralentissement) de ces structures 3D, on peut procéder à des analyses de Microscopie Electronique à Balayage (MEB) ou de Microscopie Electronique en Transmission (MET ou TEM pour l'acronyme anglais de « Transmission Electron Microscopy ») ou encore ou de Microscopie Electronique en Transmission à Balayage (STEM pour l'acronyme anglais de « Scanning Transmission Electron Microscopy »).

Le TEM ou le STEM se prêtent notamment bien à l'observation et à l'identification des puits quantiques - dont l'épaisseur est généralement de l'ordre de quelques nanomètres - dans la région active. Différentes techniques listées ci-après de façon non exhaustive peuvent être mises en œuvre : l'imagerie en champ sombre (dark field) et en champ clair (bright field), en faisceau faible (weak beam), en diffraction aux grands angles HAADF (acronyme anglais de « High Angle Annular Dark Field »).

Les compositions chimiques des différents éléments peuvent être déterminées à l'aide de la méthode bien connue EDX ou X-EDS, acronyme de « energy dispersive x-ray spectroscopy » qui signifie « analyse dispersive en énergie de photons X ».

Cette méthode est bien adaptée pour analyser la composition de dispositifs optoélectroniques de petites tailles telles que des LED 3D. Elle peut être mise en œuvre sur des coupes métallurgiques au sein d'un Microscope Electronique à Balayage (MEB) ou sur des lames minces au sein d'un Microscope Electronique en Transmission (MET).

Les techniques mentionnées ci-dessus permettent notamment de déterminer si un dispositif optoélectronique à structure 3D comprend une couche de ralentissement au sens de la présente invention, et/ou une couche de masquage indicatrice d'une mise en œuvre d'une croissance localisée, tel que décrit dans la présente invention.

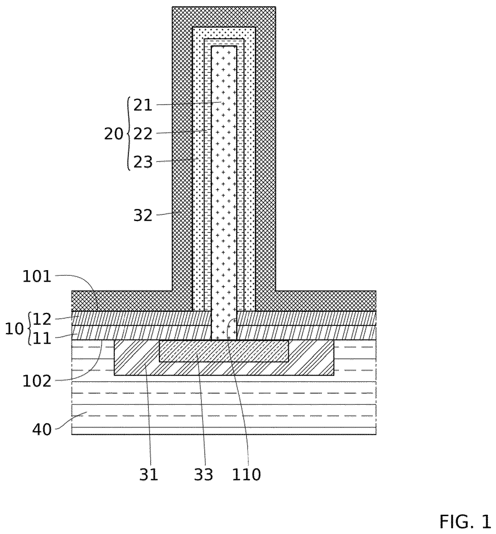

La figure 1 illustre une LED comprenant une structure 3D 20 sous forme de nanofil, selon un mode de réalisation de l'invention. La structure 3D 20 de la LED présente ici une architecture radiale également appelée cœur-coquille. Une telle architecture radiale peut notamment comprendre, de l'intérieur vers l'extérieur du nanofil selon la direction y :
- Une première partie 21 ayant un diamètre compris entre 50 nm et 1,2 µm, typiquement de l'ordre de 700 nm. Cette première partie 21 forme le noyau ou le cœur du nanofil. Elle est de préférence constituée de GaN-n.
- Une région active 22 d'épaisseur comprise entre 20 nm et 250 nm, typiquement de l'ordre de 40 nm. La région active 22 couvre les flancs et le sommet de la première partie 21. Elle est de préférence constituée d'InGaN. La région active 22 comprend de préférence des puits quantiques InGaN-i alternant avec des barrières quantiques GaN-i. Les barrières quantiques peuvent contenir de l'indium et/ou de l'aluminium. Les puits quantiques peuvent avoir une épaisseur comprise entre 1 nm et 15 nm et les barrières quantiques peuvent avoir une épaisseur comprise entre 3 nm et 20 nm. La région active 22 est configurée pour émettre un rayonnement lumineux de longueur d'onde λ.
- De façon optionnelle uniquement, une couche de blocage d'électrons (EBL) d'épaisseur comprise entre 10 nm et 100 nm, typiquement 30 nm. La couche EBL est de préférence constituée d'AlGaN. Une telle couche EBL n'est pas représentée sur la figure 1.
- Une deuxième partie 23 d'épaisseur comprise entre 20 nm et 500 nm, typiquement de l'ordre de 100 nm. La deuxième partie 23 couvre les flancs et le sommet de la région active 22. Elle est de préférence constituée de GaN-p.

La LED comprend typiquement une couche de masquage 10 mise en œuvre lors du procédé de croissance du nanofil. Cette couche de masquage 10 peut comprendre plusieurs sous-couches, par exemple une couche 11 à base de nitrure de silicium et une couche 12 à base d'oxyde. La couche de masquage 10 comprend des ouvertures 110 configurées pour favoriser la croissance locale des nanofils. Lors de la croissance, la première partie 21 traverse typiquement la couche de masquage 10 au niveau d'une ouverture 110, puis s'étend essentiellement selon z. Selon une possibilité non illustrée, la section dans le plan xy de la première partie 21 augmente brusquement à la sortie de l'ouverture 110. La première partie 21 peut ainsi prendre appui sur la face supérieure 101 de la couche de masquage 10.

La LED comprend également un premier contact 31 électriquement conducteur, configuré pour injecter des porteurs de charge dans la première partie 21. Dans l'exemple illustré, les porteurs de charge injectés par le premier contact 31 sont des électrons. Le premier contact 31 peut être métallique, par exemple à base d'aluminium. Avantageusement, ce premier contact 31 peut également être utilisé comme réflecteur optique, pour réfléchir la lumière émise par la région active 22 du côté du sommet du nanofil (c'est-à-dire du côté de la « face avant » du dispositif). Cela permet d'améliorer l'efficacité d'extraction lumineuse de la LED. Le premier contact 31 est typiquement isolé électriquement par une couche diélectrique 40, par exemple à base d'oxyde de silicium, située sur la face inférieure 102 autour du premier contact 31.

La LED comprend également un deuxième contact 32 électriquement conducteur, configuré pour injecter des porteurs de charge dans la deuxième partie 23. Dans l'exemple illustré, les porteurs de charge injectés par le deuxième contact 32 sont des trous. Le deuxième contact 32 est typiquement transparent à la longueur d'onde de la lumière émise par la région active 22. Le deuxième contact 32 est par exemple à base d'oxyde conducteur transparent TCO (acronyme de « transparent conducting oxide »), par exemple à base d'ITO (acronyme de « indium tin oxide »).

Alternativement il peut être à base d'oxyde de zinc dopé par du gallium (GZO) ou de l'aluminium (AZO).

Selon un principe de la présente invention, La LED 3D comprend avantageusement une couche de ralentissement 33 intercalée entre le premier contact 31 et la première partie 21. Cette couche de ralentissement 33 est typiquement à base d'un matériau semiconducteur magnétique dilué, par exemple à base de ZnO dopé cobalt. La transparence du ZnO n'est pas altérée par le dopage au cobalt. Ce matériau peut en outre être facilement déposé et structuré pour former la couche de ralentissement 33 à la base du nanofil.

Lors du fonctionnement de la LED, les électrons sont ralentis par la couche de ralentissement 33 avant d'arriver dans la première partie 21. En particulier, les interactions de spins entre les électrons et les atomes ferromagnétiques de la couche de ralentissement 33 modifient les trajectoires des électrons. Ces derniers suivent des trajectoires orientées aléatoirement lorsqu'ils entrent dans la première partie 21. Les électrons sont à la fois ralentis et répartis le long de toute la hauteur du nanofil. Cela permet avantageusement de favoriser les recombinaisons de porteurs dans les parties verticales de la région active 22, et de limiter les recombinaisons de porteurs dans la partie sommitale de la région active 22. Le taux de recombinaisons radiatives est plus élevé dans les plans m que dans les plans c. L'EQE est améliorée, à la fois par effet de ralentissement (la probabilité qu'un trou se recombine avec un électron augmente) et par effet de distribution dans les plans m (la probabilité qu'une recombinaison soit radiative augmente).

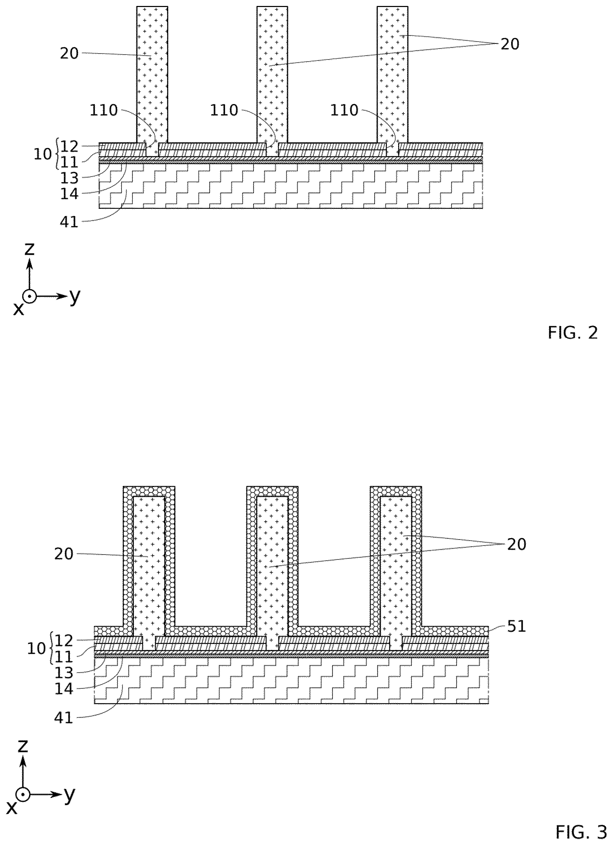

Les figures 2 à 13 illustrent différentes étapes d'un procédé de réalisation d'une LED à structure 3D 20 comprenant une couche de ralentissement 33 telle que décrite précédemment.

Dans la suite, les structures 3D 20 se présentent sous forme de nanofils. L'architecture interne de ces structures 3D 20 n'est pas détaillée. Elle peut être radiale comme illustré et décrit précédemment. Selon une possibilité alternative, les structures 3D 20 présentent une architecture interne « axiale ». Dans ce cas, de façon connue de l'homme du métier, la première partie 21 à base de GaN-n, la région active 22 à base d'InGaN-i, optionnellement la couche de blocage d'électrons à base d'AlGaN, et la deuxième partie 23 à base de GaN-p sont empilées les unes sur les autres selon z.

Comme illustré à la figure 2, les nanofils 20 sont d'abord formés sur un substrat de croissance 41. Le substrat 41 peut être à base de silicium et faire office de support. Le substrat 41 porte typiquement une ou plusieurs couches 13, 14 à base ou faite de matériaux III-V, typiquement à base de nitrure ou de carbure d'éléments métalliques. Une couche 13 superficielle, appelée couche de nucléation, permet de faire croître les nanofils 20. La couche de nucléation 13 est de préférence à base d'AIN. Elle peut être alternativement à base d'autres nitrures métalliques, par exemple GaN ou AlGaN. Elle peut être formée sur le support 41 en silicium par épitaxie, de préférence par épitaxie en phase vapeur à précurseurs organométalliques MOVPE (acronyme de « MetalOrganic Vapour Phase Epitaxy »). Elle présente avantageusement une épaisseur inférieure ou égale à 200 nm, de préférence inférieure ou égale à 100 nm, par exemple de l'ordre de 50 nm.

Une couche de masquage 10 est de préférence formée sur la couche de nucléation 13. Elle peut comprendre plusieurs sous-couches à base de matériau diélectrique, par exemple en nitrure de silicium Si3N4 et/ou en oxyde de silicium. La couche de masquage 10 peut être formée par dépôt chimique en phase vapeur CVD (acronyme de « Chemical Vapor Deposition »). Elle masque en partie la couche de nucléation 13 et comprend des ouvertures 110 de préférence circulaires exposant des zones de la couche de nucléation 13. Ces ouvertures 110 présentent typiquement une dimension, par exemple un diamètre, comprise entre 30 nm et 500 nm. Les ouvertures 110 peuvent être distribuées de façon régulière au sein de la couche de masquage 10, par exemple sous forme d'un réseau ordonné.

Une telle couche de masquage 10 permet une croissance localisée d'une structure 3D 20 au niveau de chaque ouverture 110. En particulier, lors d'une étape de croissance préliminaire appelée germination, un germe à base de GaN se forme au niveau de l'ouverture 110 puis remplit ladite ouverture 110. La croissance ultérieure du nanofil 20 se fait alors à partir de ce germe, de façon localisée.

Lors de la formation des nanofils 20, les premières parties 21, les régions actives 22 et les deuxièmes parties 23, sont successivement formées par épitaxie, de préférence par épitaxie en phase vapeur à précurseurs organométalliques MOVPE. Les nanofils 20 présentent typiquement un diamètre ou une dimension caractéristique dans le plan xy compris entre 20 nm et 1500 nm, de préférence entre 20 nm et 500 nm. Les nanofils 20 présentent de préférence un sommet sensiblement horizontal, formé par un plan polaire c (0001). Ils présentent des flancs sensiblement verticaux, formés par des plans non polaires m {10-10}.

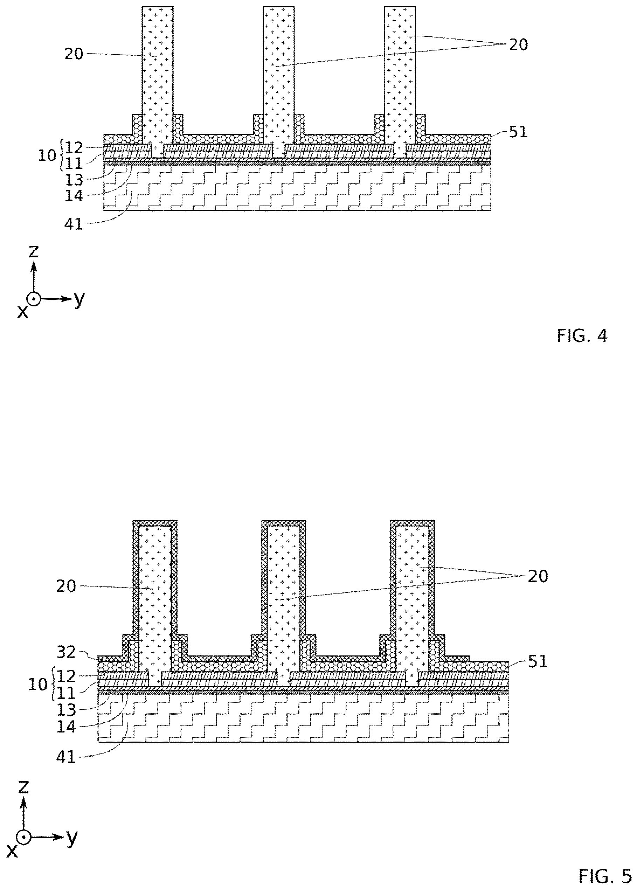

Comme illustré à la figure 3, après formation des nanofils 20 par croissance localisée au travers de la couche de masquage 10, une couche diélectrique 51 est déposée de façon conforme sur les nanofils 20 et sur les parties exposées de la couche de masquage 10. La couche diélectrique 51 est par exemple à base de SiO2. Elle peut être formée par dépôt chimique en phase vapeur assisté par plasma PECVD (acronyme de « Plasma Enhanced Chemical Vapor Deposition »). Comme illustré à la figure 4, la couche diélectrique 51 est ensuite gravée en partie, de façon à exposer les sommets et les flancs des nanofils 20 sur la quasi-totalité de leur hauteur. La gravure correspond typiquement à une gravure humide isotrope. A l'issue de la gravure, la couche diélectrique 51 est conservée sur la couche de masquage 10. Elle forme de préférence une bague à la base des nanofils 20. Elle permet de renforcer l'isolation électrique assurée en partie par la couche de masquage 10.

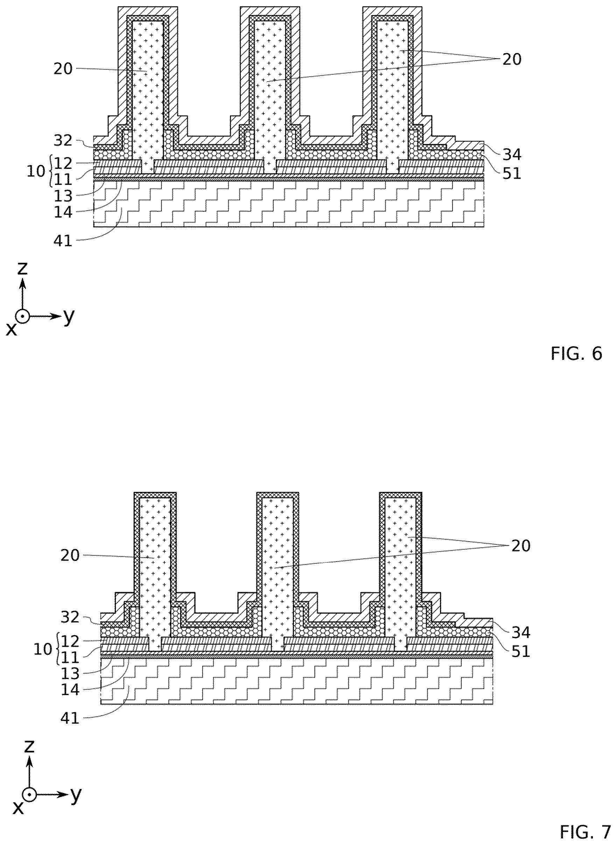

Comme illustré à la figure 5, en particulier lorsque les nanofils 20 présentent une architecture radiale, une couche à base d'un matériau conducteur électrique transparent est déposée de façon continue sur et entre les nanofils 20. Cette couche continue recouvre ici totalement les sommets et les flancs exposés des nanofils 20. Elle permet de former le deuxième contact électrique 32. Elle est typiquement à base d'un oxyde conducteur transparent, par exemple à base d'ITO, AZO ou GZO. Un recuit à haute température peut être effectué de façon à obtenir un contact ohmique entre le deuxième contact électrique 32 et la deuxième partie 23 de chaque nanofil 20. Comme illustré à la figure 6, une couche de métal 34 est ensuite déposée sur la couche continue formant le deuxième contact électrique 32. Cette couche de métal 34 est de préférence à base d'un métal réflecteur aux longueurs d'onde de la lumière émise par la région active 22. Elle est typiquement à base d'aluminium.

Comme illustré à la figure 7, la couche de métal 34 est ensuite gravée en partie, de façon à exposer la couche continue sous-jacente sur la quasi-totalité de la hauteur des nanofils 20. La gravure correspond typiquement à une gravure humide isotrope. A l'issue de la gravure, la couche de métal 34 est conservée sur le deuxième contact électrique 32 entre les nanofils 20. Elle peut former une bague à la base des nanofils 20. Elle permet de former une nappe d'alimentation électrique pour le deuxième contact électrique 32. Elle permet en outre de former un réflecteur pour la lumière émise par la région active 22. L'efficacité d'extraction lumineuse de la LED est améliorée.

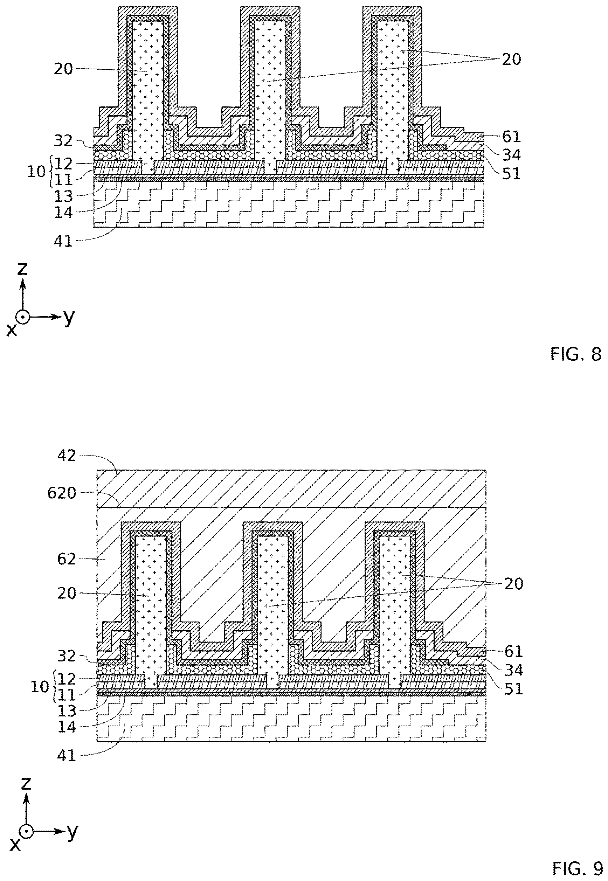

Comme illustré à la figure 8, une couche de passivation 61 peut ensuite être déposée sur les parties exposées du deuxième contact électrique 32 et sur la couche de métal 34. Cette couche de passivation 61 est par exemple à base d'un alliage d'aluminium, par exemple à base d'Al2O3. Elle peut être en un matériau diélectrique. Elle peut être formée par dépôt chimique en phase vapeur assisté par plasma PECVD.

Comme illustré à la figure 9, les nanofils 20 en saillie du substrat 41 sont ensuite planarisés par une couche de planarisation 62. Cette couche de planarisation 62 est typiquement déposée entre et sur les nanofils 20, puis polie par polissage mécano-chimique (CMP) afin d'obtenir une surface plane 620 au-dessus des nanofils 20. Cette couche de planarisation 62 est typiquement isolante électriquement et transparente.

Un substrat de manipulation 42, également appelé « poignée », est ensuite collé par adhésion moléculaire sur la surface plane 620, en « face avant ». Ce substrat de manipulation 42 peut être transparent, par exemple à base de verre. Dans ce cas il peut être conservé dans le dispositif final, à l'issue du procédé de fabrication. Alternativement, le substrat de manipulation 42 est opaque, par exemple à base de silicium. Dans ce cas il est typiquement retiré en fin de procédé de fabrication, après réalisation des étapes dédiées à la « face arrière » du dispositif.

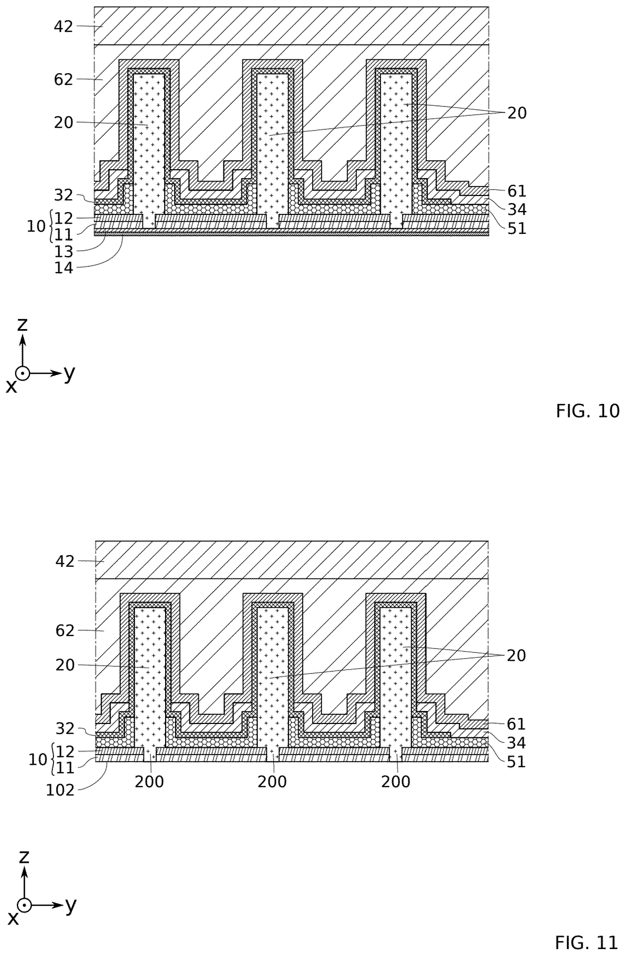

Comme illustré à la figure 10, après collage du substrat de manipulation 42, le substrat de croissance 41 est retiré. Ce retrait peut se faire de façon connue par une étape de rodage mécanique suivie d'une étape de gravure sèche.

Comme illustré à la figure 11, les couches 13, 14 à base de matériaux III-V utilisées précédemment pour la germination/nucléation des nanofils 20, sont ensuite retirées à partir de la face arrière, typiquement par une ou plusieurs gravures sèches. A l'issue du retrait des couches 13, 14, la face inférieure 102 de la couche de masquage 10 est exposée. Les portions 200 de nanofil 20 enserrées par la couche de masquage 10, correspondant initialement aux germes formés lors des étapes de germination/nucléation, sont également exposées à l'issue du retrait des couches 13, 14.

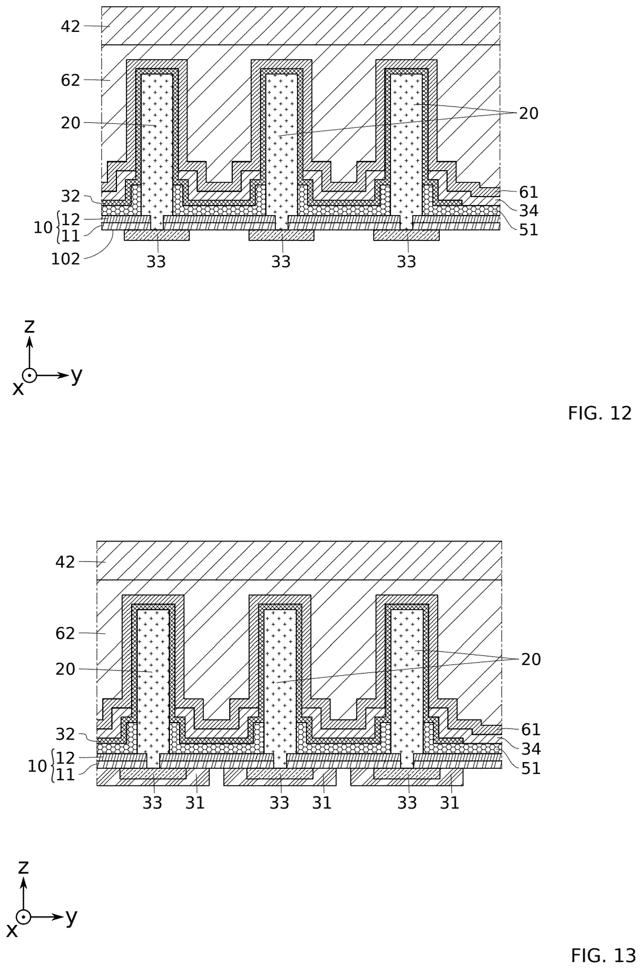

Comme illustré à la figure 12, une couche de ZnO dopée au cobalt est déposée sur la face inférieure 102 et au contact des portions 200, puis gravée de façon à former les plots 33 correspondant aux couches de ralentissement de la LED. Le dépôt peut se faire avantageusement par différentes techniques classiques de dépôt physiques ou chimiques en phase vapeur, par exemple par dépôt assisté par laser pulsé PLD (acronyme de « Pulsed Laser Deposition »), ou par dépôt en couches atomiques ALD (acronyme de « Atomic Layer Deposition »). Les plots 33 de ZnO dopé cobalt sont avantageusement ferromagnétiques à température ambiante. Ils forment également un contact ohmique avec les portions 200 des nanofils 20. Ils sont en outre transparents.

Comme illustré à la figure 13, selon une possibilité, les premiers contacts électriques 31 sont formés directement sur les plots 33 de ZnO dopé cobalt. Ils recouvrent toutes les surfaces libres des plots 33 et prennent appui sur la face inférieure 102. Les premiers contacts électriques 31 sont de préférence métalliques, typiquement à base d'aluminium. Ils assurent indirectement l'alimentation électrique des nanofils 20, par l'intermédiaire des plots 33 de ralentissement. Les premiers contacts électriques 31 forment également des réflecteurs en face arrière, afin de rediriger la lumière émise par les nanofils vers la face avant du dispositif.

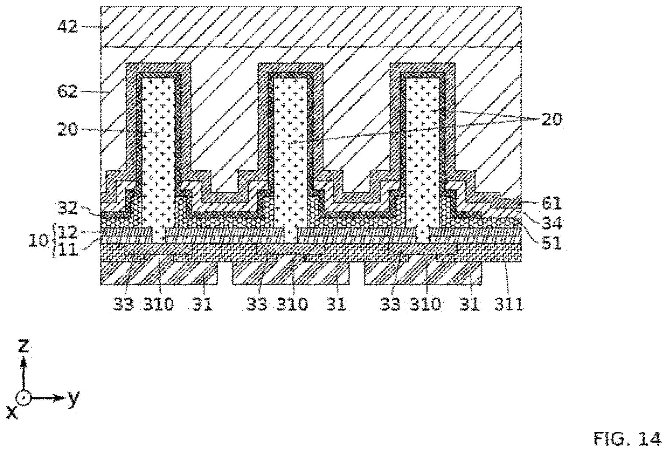

Comme illustré à la figure 14, selon une autre possibilité, avant formation des premiers contacts électriques 31, une couche diélectrique 311 est déposée en face arrière sur la face inférieure 102 et sur les plots 33 de ZnO dopé cobalt. Des vias 310 sont alors formés au sein de la couche diélectrique 311, à l'aplomb des plots 33. Les premiers contacts électriques 31 sont alors formés sous forme de plots, sur la couche diélectrique 311, au contact des vias 310 préalablement remplis. Le remplissage des vias 310 et la formation des premiers contacts électriques 31 peut se faire simultanément en une seule étape.

Après formation des premiers contacts électriques 31, la LED à base de nanofils 20 peut être connectée en face arrière, soit directement à une alimentation électrique, soit à une électronique de pilotage de la LED, par exemple basée sur la technologie de transistors complémentaires CMOS (acronyme de « Complementary Metal-Oxide-Semiconductor »). Le substrat de manipulation 42 peut être retiré, le cas échéant.

Il apparaît que la LED 3D selon l'invention est plus efficace qu'une LED 3D classique, en particulier pour une architecture radiale. Cela est particulièrement avantageux pour des technologies de LED fonctionnant à moyenne ou haute tension.

L'invention n'est pas limitée aux modes de réalisations précédemment décrits. L'homme du métier saura sans difficulté adapter les exemples de réalisation décrits ci-dessus au cas d'une LED 3D présentant une architecture axiale.

## Revendications

1. Diode électroluminescente comprenant au moins une structure tridimensionnelle (3D) comprenant :
• une première partie (21) présentant une première conductivité d'un premier type de porteurs,
• une deuxième partie (23) présentant une deuxième conductivité d'un deuxième type de porteurs,
• une région active (22) configurée pour émettre ou recevoir un rayonnement lumineux de longueur d'onde λ, ladite région active (22) étant intercalée entre la première partie (21) et la deuxième partie (23),
la diode comprenant en outre :
• Un premier contact (31) électriquement conducteur configuré pour injecter des porteurs du premier type dans la première partie (21),
• Un deuxième contact (32) électriquement conducteur configuré pour injecter des porteurs du deuxième type dans la deuxième partie (23),
ladite diode électroluminescente étant **caractérisée en ce qu'**elle comprend une couche (33) de ralentissement de porteurs intercalée entre le premier contact (31) et la première partie (21), ladite couche (33) de ralentissement étant configurée pour ralentir les porteurs du premier type issus du premier contact (31) avant d'être injectés dans la première partie (21).

2. Diode selon la revendication précédente, dans laquelle les porteurs du premier type sont des électrons et la première conductivité est de type N, les porteurs du deuxième type sont des trous et la deuxième conductivité est de type P, et la couche de ralentissement (33) est une couche de ralentissement d'électrons à base d'un matériau semiconducteur magnétique dilué.

3. Diode selon la revendication précédente, dans laquelle le matériau semiconducteur magnétique dilué est à base de ZnO dopé par au moins un élément pris parmi le cobalt (Co), le manganèse (Mn), le niobium (Nb), le chrome (Cr), le fer (Fe), le nickel (Ni), le néodyme (Nd).

4. Diode selon l'une quelconque des revendications précédentes comprenant en outre une couche de masquage (10) présentant une face (102) dite inférieure, une face (101) dite supérieure, et des ouvertures (110), dans laquelle la première partie (21) traverse la couche de masquage (10) au niveau desdites ouvertures (110), jusqu'à la couche de ralentissement (33), la couche de ralentissement (33) étant au contact de la face inférieure (102) de la couche de masquage (10).

5. Diode selon la revendication précédente dans laquelle la structure 3D (20) est obtenue par croissance localisée au travers des ouvertures (110) de la couche de masquage (10).

6. Diode selon l'une quelconque des revendications précédentes dans laquelle la structure 3D (20) présente une architecture dite radiale telle que :
• la première partie (21) s'étend principalement selon une direction z, et présente des flancs sensiblement parallèles à la direction z et un sommet sensiblement perpendiculaire à la direction z,
• la région active (22) comprend une partie dite radiale couvrant les flancs de la première partie (21), et une partie dite sommitale couvrant le sommet de la première partie (21),
• la deuxième partie (23) couvre la partie radiale et la partie sommitale de la région active (22).

7. Diode selon la revendication précédente dans laquelle la partie radiale forme au moins 80% de la région active (22), et dans laquelle la couche de ralentissement (33) s'étend de façon transverse à ladite partie radiale.

8. Diode selon l'une quelconque des revendications précédentes dans laquelle la première partie (21) et la couche de ralentissement (33) présentent une interface commune.

9. Diode selon l'une quelconque des revendications 1 à 5 dans laquelle la structure 3D (20) présente une architecture dite axiale formant un empilement selon une direction z tel que :
• la première partie (21) présente des flancs sensiblement parallèles à la direction z et un sommet sensiblement perpendiculaire à la direction z,
• la région active (22) couvre uniquement le sommet de la première partie (21), et présente des flancs sensiblement parallèles à la direction z à l'aplomb des flancs de la première partie (21), et un sommet sensiblement perpendiculaire à la direction z,
• la deuxième partie (23) couvre uniquement le sommet de la région active (22), et présente des flancs sensiblement parallèles à la direction z à l'aplomb des flancs de la région active (22).

10. Diode selon l'une quelconque des revendications précédentes comprenant en outre une couche de blocage du premier type de porteurs intercalée entre la deuxième partie (23) et la région active (22).

11. Procédé de réalisation d'une diode électroluminescente comprenant au moins une structure tridimensionnelle (3D) selon l'une quelconque des revendications précédentes, ledit procédé comprenant :
• former la première partie (21),
• former par épitaxie la région active (22) sur la première partie (21),
• former par épitaxie la deuxième partie (23) sur la région active (22),
• former le deuxième contact (32) sur la deuxième partie (23),
• former la couche de ralentissement (33) au contact de la première partie (21),
• former le premier contact (31) sur la couche de ralentissement (33).

12. Procédé de réalisation selon la revendication précédente, ledit procédé comprenant :
• former la première partie (21) par épitaxie sur un substrat de croissance (41), par croissance localisée au travers d'une ouverture (110) d'une couche de masquage (10) disposée sur ledit substrat de croissance (41),
• former par épitaxie la région active (22) sur la première partie (21),
• former par épitaxie la deuxième partie (23) sur la région active (22), puis
• former le deuxième contact (32) sur la deuxième partie (23), par dépôt d'une couche d'oxyde conducteur transparent,
• déposer une couche de planarisation (62) sur le substrat de croissance (41), sur et autour de l'au moins une structure 3D (20) en saillie du substrat de croissance (41), de façon à obtenir une surface plane (620) au-dessus de l'au moins une structure 3D (20),
• coller un substrat de manipulation (42) sur ladite surface plane (620),
• retirer le substrat de croissance (41) de façon à exposer une portion (200) de la première partie (21) au travers de la couche de masquage (10),
• former la couche de ralentissement (33) au contact de la portion (200) exposée de la première partie (21),
• former le premier contact (31) sur la couche de ralentissement (33).

13. Procédé selon la revendication précédente, dans lequel le substrat de manipulation (42) est à base d'un matériau transparent à la longueur d'onde λ d'émission de la diode électroluminescente.

14. Procédé selon l'une quelconque des revendications 12 à 13, dans lequel la couche de ralentissement (33) est structurée sous forme de plot, et le premier contact (31) est formé sur et autour dudit plot (33), en prenant appui sur une face inférieure (102) de la couche de masquage (10).

15. Procédé selon l'une quelconque des revendications 12 à 14 comprenant en outre, après formation de la couche de ralentissement (33), un dépôt d'une couche diélectrique (311) sur la couche de ralentissement (33), puis une gravure d'un via (310) au travers de la couche diélectrique (311) débouchant sur une face de la couche de ralentissement (33), et la formation du premier contact (31) au travers dudit via (310).

16. Procédé selon l'une quelconque des revendications 11 à 15, dans lequel les formations des première et deuxième parties (21, 23), et la formation de la région active (22), sont effectuées par épitaxie en phase vapeur à précurseurs organométalliques (MOVPE).
